# EUROPÄISCHE PATENTSCHRIFT

(11) **EP 0 597 053 B1**
(45) Veröffentlichungstag und Bekanntmachung des Hinweises auf die Patenterteilung: **20.08.1997**
(21) Anmeldenummer: 93909740.8
(22) Anmeldetag: 21.05.1993
(51) Int. Cl.: F27B 17/00, F27B 5/16, F26B 21/02, C30B 31/12, H01L 21/00

(54) **VORRICHTUNG ZUR WÄRMEBEHANDLUNG EINES MAGAZINS FÜR SYSTEMTRÄGER MIT ELEKTRONISCHEN BAUELEMENTEN**
DEVICE FOR HEAT-TREATING A MAGAZINE FOR LEAD FRAMES WITH ELECTRONIC COMPONENTS
DISPOSITIF POUR LE TRAITEMENT THERMIQUE D'UN MAGASIN POUR DES GRILLES DE CONNEXION POURVUES DE COMPOSANTS ELECTRONIQUES

(30) Priorität: 03.06.1992 CH 1786/92
(43) Veröffentlichungstag der Anmeldung: 18.05.1994
(73) Patentinhaber: ESEC SA, CH-6330 Cham/Steinhausen (CH)
(72) Erfinder: MEISSER, Claudio, CH-6330 Cham (CH); HONEGGER, Rolf, CH-8810 Horgen (CH)
(74) Vertreter: EGLI-EUROPEAN PATENT ATTORNEYS
(86) Internationale Anmeldenummer: CH9300131
(87) Internationale Veröffentlichungsnummer: WO9324801

(56) Entgegenhaltungen:
- WO-A-84/04808
- WO-A-91/02106
- FR-A- 2 079 146
- GB-A- 2 090 962
- US-A- 3 429 057
- US-A- 4 914 834

## Beschreibung

Die Erfindung betrifft einen Aushärteofen gemäss dem Oberbegriff von Anspruch 1.

Die Konkurrenzfähigkeit bei der Massenproduktion von Halbleitern ist heute vor allem eine Frage der Ausbeute an qualitativ einwandfreien Bauteilen. Die entsprechenden Produktionslose müssen ohne wesentliche Zunahme der Kosten und ohne verlängerte Lieferzeit bereitgestellt werden. Diese Herausforderung bedingt den Einsatz von Prozessen und Anlagen mit höchster Zuverlässigkeit und Produktivität, wobei auch kleinste Losgrössen zu bearbeiten sind, ohne dass die Rentabilität durch die Losgrösse beeinträchtigt wird. Hierzu sind verschiedene Linienkonzepte entwickelt worden, um in Magazinen angeordnete und mit elektronischen Bauelementen (sogenannte Chips) bestückte Systemträger (sogenannte Leadframes) einzelnen Verdrahtungsstationen (sogenannten Wire-Bondern) zuzuführen. Die Systemträger werden dabei von Arbeitsstation zu Arbeitsstation geführt.

Eine dieser Arbeitsstationen besteht aus einer Aushärtungsanlage, in welcher ein sogenanntes Curing stattfindet, d.h. eine Aushärtung durch Polymerisation der Epoxyharze und hier insbesondere der Klebstoffe, die zur Befestigung der elektronischen Bauelemente auf die Systemträger verwendet werden.

Dazu wurden bisher eine Mehrzahl von Magazinen mit Systemträgern in einen entsprechenden Ofen gebracht und mit heissem Gas (Luft oder Schutzgas) beaufschlagt. Dieses ungeordnete Wärmebehandeln hat aber erhebliche Nachteile bezüglich des Aushärteprozesses, des Temperaturprofils, der Beanspruchung der elektronischen Bauteile und der einhergehenden Verschmutzung der Bauteile, der Systemträger und der Umwelt.

Aufgabe der vorliegenden Erfindung ist es, eine Aushärtungsanlage zu schaffen, bei welcher die obengenannten Nachteile nicht auftreten, indem die entsprechenden Systemträger gezielt und kontrolliert so behandelt werden, dass eine regelmässige Aushärtung über die gesamte Länge des Systemträgers stattfindet und die darauf vorhandenen elektronischen Bauelemente einer möglichst geringen Beanspruchung unterworfen werden, wobei deren Verschmutzung und die Belastung der Umwelt so gering wie möglich gehalten werden.

Die Aufgabe wird erfindungsgemäss durch einen Aushärteofen gemäss Patentanspruch 1 gelöst.

Dadurch wird die Wärmeübertragung zwischen dem Gas und den elektronischen Bauelemente auf den Systemträgern im Magazin beachtlich erhöht und folglich die Zeitdauer, die zum Aufheizen oder Kühlen der elektronischen Bauelemente auf den Systemträgern im Magazin benötigt wird, beachtlich reduziert. So werden die sehr temperaturempfindlichen elektronischen Bestandteile der elektronischen Bauelemente möglichst wenig und zudem gleichmässig mit hohen Temperaturen beaufschlagt. Optimal ist es nämlich, die Bauelemente nur solange als nötig mit hohen Temperaturen zu beaufschlagen, um beispielsweise darin enthaltene Harze auszuhärten bzw. allgemein die gewünschten chemische Reaktionen darin ablaufen zu lassen.

Obwohl die gestellten Erwartungen bezüglich der Temperaturkonstanz in dem Magazin bereits in diesem Ausbildungsbeispiel erfüllt werden, kann die Zeit, bis die elektronischen Bauteile auf der Gasaustrittseite des Magazins nahezu die gleiche Temperatur wie auf der Gaseintrittsseite haben, noch weiter verkürzt werden.

Vorzugsweise befindet sich zumindest ein Teil der Heizung auf einer im wesentlichen horizontalen Strecke eines vom Magazin zum Ventilator oder vom Ventilator zum Magazin führenden Gasstroms. In einer Ausbildung der erfindungsgemässen Vorrichtung ist dabei die Heizung zweiteilig, während sich je ein Teil der Heizung auf den jeweiligen Strecken der vom Magazin zum Ventilator und vom Ventilator zum Magazin führenden Gasströme befindet. Durch diese Anordnung der Heizung wird die Gefahr von Temperaturschichtungen vermieden, da das erwärmte Gas in dem Ventilator verwirbelt und somit sehr gut vermischt wird.

Vorzugsweise ist das mindestens eine Gasleitelement zwischen dem Ventilator und dem Magazin angeordnet, wobei dieses Gasleitelement bevorzugt als Leitblech, Wand, Gasleitstutzen und dergleichen ausgebildet ist. Durch diese Gasleitelemente erfolgt eine gezielte Zuleitung des Gasstromes zu den Systemträgern im Magazin. Der Gasstron wird mittels eines entsprechenden Ventilators durch die Heizung angesaugt und/oder ausgestossen und dann dem Magazin mit den Systemträgern zugeführt, um dieses Magazin zu durchfliessen, damit die Systemträger wärmebehandelt werden.

In einer Ausbildung der erfindungsgemässen Vorrichtung ist zumindest einer der Ventilatoren als Schraubenventilator, d.h. als Ventilator mit schraubenförmigen Flügeln, mit einer zur Längsrichtung des Magazins in wesentlichen parallelen Richtung seiner Welle und seines Gasausstosses ausgebildet, und das Gasleitelement ist als Leitblech ausgebildet, welches zwischen dem Magazin und den Ventilator sitzt und zusammen mit Seitenwänden des Gehäuses der Box Zwangsschächte ausbildet. Dabei kann die Richtung des Gasstromes vorzugsweise durch Umkehr der Drehrichtung des Schraubenventilators änderbar sein, beispielsweise indem die Drehrichtung der Flügel alternierend umgekehrt wird. Diese Umkehr der Drehrichtung kann beispielsweise mit einer Periodizität von 10 bis 30 Sekunden, vorzugsweise von 10 Sekunden erfolgen. So kann das Magazin von beiden Seiten mit heissen Gas beaufschlagt werden, um Ungleichmässigkeiten der Wärmeübertragung weiter zu vermindern, welche beispielsweise durch die geringe Wärmekapazität des nur langsam durch das Magazin fliessenden Gases, mit der die Wärmeleistung ins Innere des Magazins gebracht werden soll, verursacht würden.

In einer anderen Ausbildung der erfindungsgemässen Vorrichtung ist durch als Gasleitelemente wirkende Kammerwände im Anschluss an einen der Ventilatoren mindestens ein Schacht ausgebildet, der einen Gasstrom den im Magazin angeordneten Systemträgern einseitig zuleitet. Dabei kann ein Ventilator als Radialventilator, d.h. als Ventilator mit radialen Flügeln ausgebildet sein, während die Richtung des Gasstromes durch Öffnen bzw. Schliessen von entsprechenden Zwangsschächten vorzugsweise mittels mechanisch betätigbarer Abschlussbleche bzw. Klappen änderbar ist. Analog zum vorangehenden und mit gleichartigen Gründen und Vorteilen kann diese Betätigung der Abschlussbleche bzw. Klappen beispielsweise mit einer Periodizität von 10 bis 30 Sekunden, vorzugsweise von 10 Sekunden erfolgen.

In einer noch anderen Ausbildung der erfindungsgemässen Vorrichtung sind durch zumindest ein als Gasleitelement wirkendes Leitblech bzw. eine als Gasleitelement wirkende Wand zwei Zwangsschächte bzw. Führungsschächte ausgebildet, durch welche je ein Gasstrom vom Magazin zu einem Ventilator bzw. von einem Ventilator zum Magazin geführt wird. In diesen beiden Ausbildungen kann das Gas durch den einen Schacht vom Magazin her angesaugt, erwärmt und gegebenenfalls durch den anderen, beispielsweise gegenüberliegenden Schacht wieder dem Magazin zugeführt werden, oder umgekehrt.

In einer weiteren Ausbildung der erfindungsgemässen Vorrichtung sind in der Box zwei Ventilatoren angeordnet, die als Radialventilatoren ausgebildet sind und das Magazin in jeweils entgegengesetzte Richtungen mit Gas beaufschlagen. Somit kann das Gas in dieser Ausbildung in einem oberen bzw. unteren Bereich der Box in jeweils entgegengesetzten Richtungen durch den einen Schacht vom Magazin her angesaugt, erwärmt und durch den anderen, beispielsweise gegenüberliegenden Schacht wieder dem Magazin zugeführt werden. Vorzugsweise ist dabei jedem Ventilator ein vorzugsweise mit einem Ringflansch versehener Gasleitstutzen zugeordnet, wobei dieser Gasleitstutzen in einer Wand sitzt, die an eine Rückwand der Box anschliesst und zum Magazin hin einen Führungsschacht ausbildet. Dabei kann die Heizung als Heizspirale ausgebildet und zwischen den Gasleitstutzen der beiden Ventilatoren angeordnet sein, wobei eine Wendelachse der Heizspirale im wesentlichen vertikal und jeweilige Längsachsen der Gasleitstutzen im wesentlichen horizontal angeordnet ist. Dabei kann eine Verteilung des Gasstromes in der Box durch gleichzeitige Umkehr der Drehrichtung der beiden Ventilatoren periodisch änderbar sein, beispielsweise indem die Drehrichtung der Flügel alternierend umgekehrt wird. Analog zum vorangehenden und mit gleichartigen Gründen und Vorteilen kann diese gemeinsame Umkehr der Drehrichtung der beiden Ventilatoren beispielsweise mit einer Periodizität von 10 bis 30 Sekunden, vorzugsweise von 10 Sekunden erfolgen.

Mit diesen bevorzugten Massnahmen bzw. deren verschiedenen erfindungsgemässen Kombinationen wird unter anderem eine verbesserte und daher beschleunigte Erwärmung des Gases in der Box und/oder der Systemträger im Magazin erreicht. Insbesondere führt die Verwendung von zwei Ventilatoren und die gemeinsame periodische Umkehr ihrer Drehrichtung zu einer Kompensation, jeweils in oberen bzw. unteren Teilbereichen der Box, von etwas höheren Geschwindigkeiten des Gasflusses in der einen Durchflussrichtung durch etwas geringere Geschwindigkeiten des Gasflusses in der anderen Durchflussrichtung, wobei umgekehrte Verhältnisse jeweils für den oberen bzw. unteren Teilbereich der Box gelten. Dadurch läuft die Wärmebehandlung, beispielsweise die Aushärtung, wesentlich gleichmässiger ab und sie wird auch beschleunigt.

Zum Antrieb sind die Ventilatoren vorzugsweise mit jeweiligen Motoren, beispielsweise Elektromotoren, versehen und damit über Wellen verbunden, wobei die Motoren jeweils ausserhalb des Gehäuses der Box angeordnet sind, gleichsinnig drehen und auf etwa gegenüberliegenden Seitenwandstreifen des Gehäuses angeordnet sind. Dabei können die im wesentlichen vertikalen Seitenwandstreifen vorzugsweise schräg von einer im wesentlichen vertikalen Rückwand des Gehäuses der Box weg verlaufen, wobei diese Rückwand schmaler ist als die im wesentlichen vertikale Beschickungsöffnung der Box. Vorzugsweise können zudem, bei der entsprechenden Ausbildung der Vorrichtung mit zwei Ventilatoren, jeweils ein Gasleitstutzen und eine Welle im wesentlichen kongruente Längsachsen aufweisen, die sich im wesentlichen im Mittelpunkt der Heizspirale bzw. auf deren Wendelachse treffen und vorzugsweise einen stumpfen Winkel einschliessen, so dass die Ventilatoren schräg zueinander geneigt angeordnet sind.

Mit diesen bevorzugten Massnahmen wird unter anderem erreicht, dass die Ventilatoren das Gas in eine geschlossene Kammer schleudern und andererseits dieses Gas nur durch einen gut definierten und optimal gestalteten Führungsschacht zirkuliert. Dadurch ist ein vorbestimmter und ausgerichteter Gasstrom gewährleistet.

Die Schrägstellung der Ventilatoren bringt noch weitere wesentliche Vorteile. Zum einen ist bekannt, dass jede Umlenkung des Gases zu einem Druckabfall führt, so dass ein gewünschter Gasstrom stark verringert wird. Aus diesem Grund sollten in der erfindungsgemässen Box möglichst wenig Umlenkungen des Gases vorkommen. Dies wird durch die Schrägstellung erreicht, da das dort gebildete Knie eher noch zu einer verbesserten Einleitung des Gases infolge der Wandabstrahlung zum Magazin hin führt. Ein weiterer Vorteil ist, dass das Seitenwandteil, in dem der Motor sitzt, schräg ausgebildet sein kann. Dementsprechend ist die Rückwand der Box im Vergleich zur Tür oder Beschickungsöffnung kürzer ausgebildet. Hierdurch bildet sich neben der Box ein freier Raum, in den lediglich der Motor einragt, wobei jedoch der Motor nicht über die Hauptebene der Seitenwand hinausragt. Damit ist es möglich, mehrere Boxen nebeneinander und auch übereinander zu stellen, ohne dass sie sich gegenseitig behindern. Ferner kommt eine derartige Anordnung mit dem kleinsten Innenraum aus, was sich wiederum positiv auf die Gasströmung auswirkt.

Vorzugsweise ist in der Box ein vom Gehäuse thermisch entkoppelter Magazinträger vorgesehen, auf dem mindestens ein Magazin in einer in etwa vor der Beschickungsöffnung zentrierten Lage abstützbar ist. Auf diese Weise kann das Magazin in mittlerer Höhe der Box angeordnet und dadurch gleichmässiger vom Gasstrom werden.

Dabei kann ein Temperatursensor im wesentlichen im Zentrum des Magazinträgers und thermisch damit gekoppelt angeordnet sein, wobei der Magazinträger den Temperatursensor vor einer direkten Wärmebestrahlung durch die Heizspirale der Heizung abschirmt. Ausserdem können in der Box zusätzlich zum Temperatursensor mindestens zwei Gastemperaturfühler vorgesehen sein, die relativ zueinander im wesentlichen in gleicher Höhe angeordnet sind und von denen jeweils mindestens einer den Gasstrom je eines der beiden Zwangsschächte bzw. Führungsschächte zugeordnet ist, um dessen Temperatur zu fühlen. Auf diese Weise kann die Temperatur der Bauteile im Magazin am besten erfasst und optimal überwacht werden.

Zum Antrieb eines Ventilators kann vorzugsweise eine mit einem ausserhalb der Box angeordneten Antrieb oder Motor verbundene Welle des Ventilators eine am Gehäuse angeordnete Wellendichtung durchfahren, wobei diese Wellendichtung eine Wellendurchführung aufweist, welche einen grösseren Durchmesser hat als denjenigen der Welle und in welche eine Radialleitung zur Zuführung eines Gases, vorzugsweise eines Schutzgases wie Stickstoff, einmündet. Im besonderen Falle des bereits erwähnten Schraubenventilators mit einer zur Längsrichtung des Magazins im wesentlichen parallelen Richtung seiner Welle und seines Gasausstosses kann vorzugsweise die Welle des Schraubenventilators über eine Magnetkupplung mit einem ausserhalb der Box angeordneten Antrieb oder Motor verbunden sein. Mit diesen Massnahmen wird erreicht, dass der Antrieb des Ventilators keine Undichtigkeit des Gehäuses der Box verursacht, durch welche das Gas von aussen her mit Luft und Staub verunreinigt werden könnte oder Verunreinigungen mit dem Gas nach aussen dringen könnten. Im Falle der Wellendurchführung mit Schutzgas umspült dieses Gas die Welle und es tritt dann sowohl in den Inneraum der Box ein als auch aus dem Gehäuse aus, so dass an der Wellendurchführung gar keine Reibung stattfindet und somit keine Lagerwärme erzeugt wird, sondern im Gegenteil die Welle durch das Schutzgas gekühlt wird. Zudem sind die Motoren ausserhalb der Box angeordnet, so dass deren Beschädigung durch die erhebliche Wärme in der Box vermieden wird und auch keine Lagerung der Welle des Motors heisslaufen kann.

Es versteht sich, dass an der Box eine Zuführleitung vorgesehen ist, mittels der zum einen frisches Gas, beispielsweise ein Schutzgas wie Stickstoff oder dergleichen, in den Innenraum der Box eingebracht werden kann, beispielsweise um eine Oxidation der Teile der Systemträger zu verhindern. Dann ist an der Box auch eine Abführleitung vorgesehen, mittels welcher das mit schädlichen Stoffen versetzte Gas aus dem Innenraum der Box abgeleitet werden kann. Wenn beispielsweise eine Polymerisation von Epoxyharzen stattfindet, sollte dieses Gas auch entsprechend entsorgt werden.

Für die Leitbleche sind selbstverständlich auch noch weitere Ausgestaltungen denkbar. Vor allem ist es möglich, die Leitbleche als steuerbare Abschlussbleche bzw. Klappen auszubilden, so dass hier noch eine gezieltere Beeinflussung des Gasstromes stattfinden kann. Allerdings ist dann auch der Aufwand erheblicher.

Ein Aspekt der Erfindung betrifft auch die Tür bzw. das Öffnen der Box. Hier geht es vor allem darum, dass möglichst wenig Luft aus der Umgebung beim öffnen und Schliessen der Tür in den Innenraum der Box gebracht wird, da diese Luft mit Schmutzpartikeln versetzt ist, die sich auf den Systemträgern festsetzen könnten und zu Störungen führen würden, und gegebenenfalls zur Vermeidung von Oxydation durch ein Schutzgas zu spülen ist.

Vorzugsweise kann dazu die Tür über eine Parallelogrammführung mit einem die Box abstützenden Hauptgehäuse verbunden sein. Diese Parallelogrammführung kann vorzugsweise aus jeweils zwei gelenkig mit den Seiten der Tür und dem Hauptgehäuse verbundenen Hebeln bestehen, welche von einem Antrieb bewegbar sind. Zwischen zwei Hebeln kann vorzugsweise eine im wesentlichen horizontale Traverse angeordnet sein, in der eine Hülse mit einem Innengewinde sitzt, welches von einer ortsfesten Spindelstange durchsetzt ist. Die Spindelstange kann vorzugsweise über einen Antriebsriemen mit einem Motor verbunden sein.

Dadurch, dass die Tür durch eine Parallelogrammführung geöffnet wird, kann sie von der Beschickungsöffnung beispielsweise nach unten oder nach oben weggezogen werden, ohne dass, wie beispielsweise bei einer klappenden Tür, durch das Zuschlagen der Tür Luft in den Innenraum der Box verdrängt wird. Zudem wird die Dichtung zwischen der Box und der Tür gleichmässig beansprucht, was eine bessere Abdichtung sowie eine längere Betriebstüchtigkeit der Dichtung gewährleistet.

Die vorliegende Aushärtungsanlage hat eine Vielzahl von Vorteilen, die im einzelnen vollständig gar nicht aufgezählt werden können. Durch die Steuerung und Kontrolle fast aller Prozessparameter ist die Aufrechterhaltung eines sehr günstigen Temperaturprofils zwischen den Systemträgern und zwar sowohl bezüglich des Heizens wie auch des Kühlens möglich. Dies ist vor allem auf die gewählten Strömungsverhältnisse zurückzuführen. Die Vorrichtung eignet sich sowohl für den Betrieb bei hohen Temperaturen (für ein sogenanntes Snap Curing) und sie erlaubt die Behandlung mit Schutzgas. Die elektronischen Bauteile unterliegen einer minimalen Beanspruchung und nur einer äusserst geringen Verschmutzung. Alle Bauteile werden fast zur selben Zeit den gleichen Aushärtebedingungen ausgesetzt.

Die Anlage ist im übrigen nicht auf bestimmte Magazine beschränkt, sondern es können verschiedene Magazingrössen behandelt werden. Es sind weder Leitbleche auszutauschen noch sonstige Vorkehrungen zu treffen. Kondensationserscheinungen auf den Bauelementen oder Systemträgern sind ausgeschlossen.

Noch hervorzuheben ist die kompakte Bauform und der einfache Türmechanismus. Eine derartige Anlage ist auf einfache und sehr günstige Weise in eine bestehende Linie integrierbar.

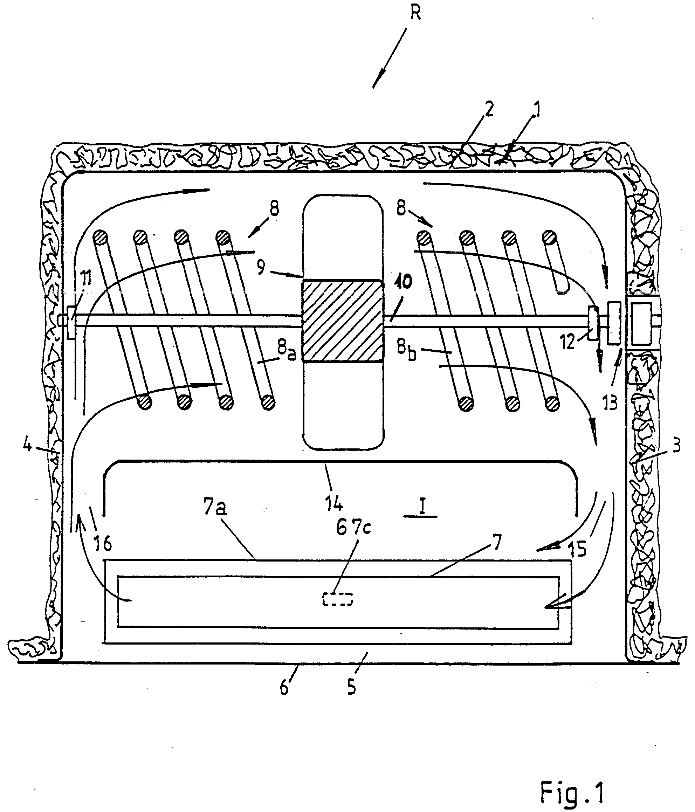

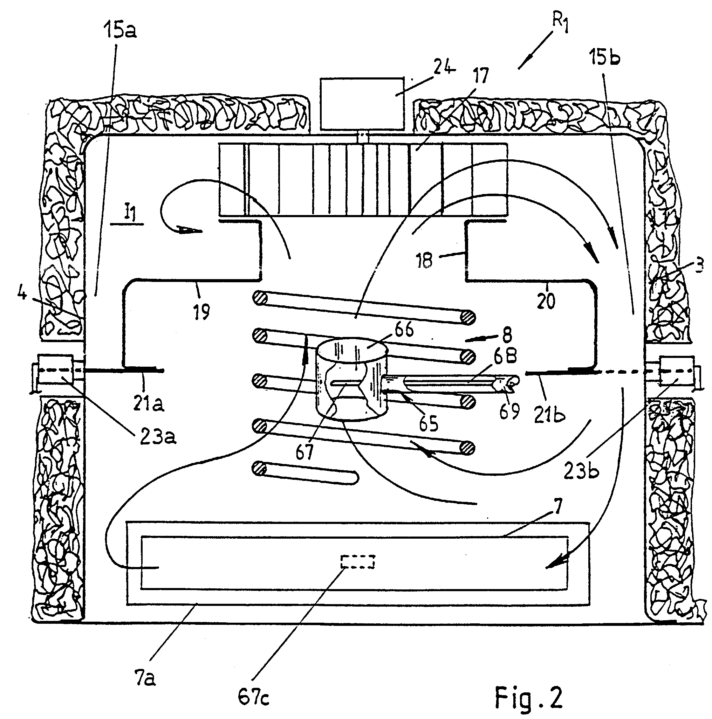

Die Erfindung wird anhand von in den Figuren schematisch dargestellten Beispielen von Aushärteofen näher erläutert. Zu deren besseren Verständnis sind darin, neben bevorzugten Ausführungsbeispielen der Erfindung auch im Rahmen der Entwicklungsarbeiten erstellte Vorstufen erfindungsgemässer Aushärteofen in den Fig. 1 und 2 gezeigt. In diesen Vorstufen sind bereits einzelne Merkmale der Erfindung verwirklicht. Es zeigen :
- Fig. 1: eine schematische Draufsicht auf eine Box in einer nicht näher gezeigten Aushärtungsanlage für Systemträger, welche mit elektronischen Bauteilen bestückt sind;
- Fig. 2: eine schematische Draufsicht auf ein weiteres Ausbildungsbeispiel einer Box für eine Aushärtungsanlage entsprechend Fig. 1;
- Fig. 3: eine schematische Draufsicht auf ein bevorzugtes Ausbildungsbeispiel einer geöffneten erfindungsgemässen Box für eine Aushärtungsanlage;
- Fig. 4: einen Querschnitt durch die Box gemäss Fig. 3;
- Fig. 5: einen teilweise dargestellten Querschnitt durch die Box gemäss Fig. 3 entlang der Linie V-V;
- Fig. 6: eine Seitenansicht eines Teils einer Aushärtungsanlage mit integrierter Box;
- Fig. 7: eine Draufsicht auf das Teil der Aushärtungsanlage gemäss Fig. 6;
- Fig. 8: eine teilweise gebrochen dargestellte Draufsicht auf eine erfindungsgemäss Wellendichtung; und
- Fig. 9: einen Querschnitt durch die Wellendichtung entlang der Linie IX-IX der Fig. 8.

Eine Box R für eine Aushärtungsanlage für Systemträger weist gemäss Fig. 1 ein allseits geschlossenes Gehäuse 1 auf, mit einer vorzugsweise vertikalen Rückwand 2, vorzugsweise vertikalen Seitenwänden 3 und 4 sowie einer vorzugsweise vertikalen Beschickungsöffnung 5, welche von Stirnkanten 29 definiert und von einer Tür 6 verschlossen ist.

In der Box R ist ein Magazinträger 7a vorgesehen, auf dem ein Magazin 7 in etwa vor der Beschickungsöffnung 5 zentriert aufgestellt und somit etwa in mittlerer Höhe der Box R angeordnet ist. Im Magazin 7 befinden sich die zu behandelnden Systemträger, so dass während eines Durchgangs in einer Box R eine Mehrzahl, beispielsweise 40, solcher Systemträger auf einmal wärmebehandelt werden können.

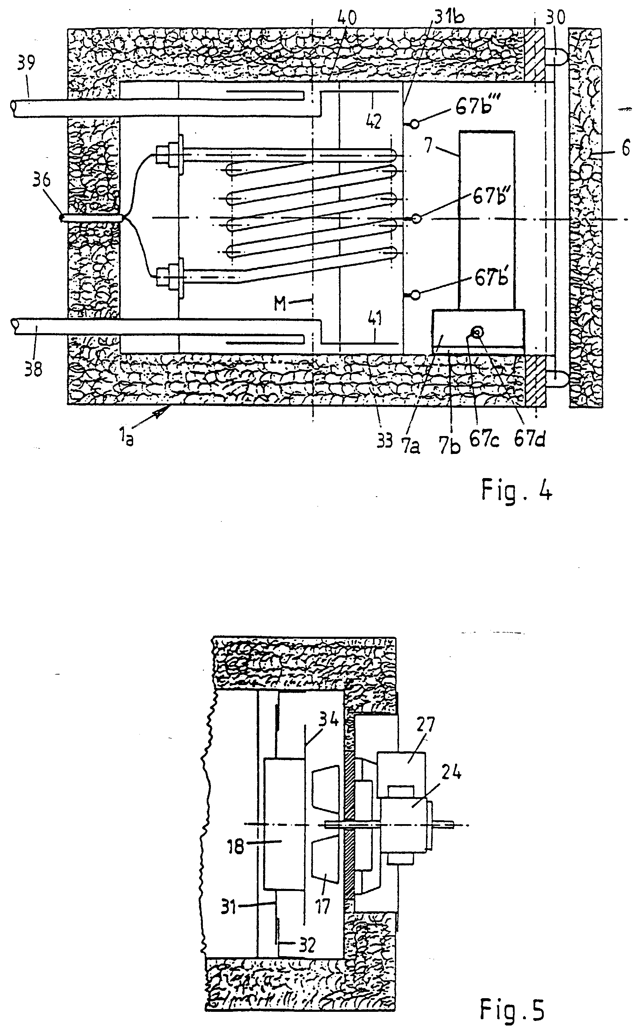

Der Magazinträger 7a ist mit dem Magazin 7 thermisch möglichst gut gekoppelt, aber vom Gehäuse 1 thermisch entkoppelt. Beispielsweise ist der Magazinträger 7a ein quaderförmiger Block aus Aluminiumlegierung, der über eine thermisch isolierende Zwischenschicht 7b beispielsweise aus Keramik (vgl. in Fig. 4) am Gehäuse 1 abgestützt ist. Das Magazin 7 ist auch aus Aluminiumlegierung und dessen Aufstellen auf den Magazinträger 7a bewerkstelligt den gewünschten thermischen Kontakt.

Im wesentlichen im Zentrum des Magazinträgers 7a und thermisch damit gekoppelt ist ein Temperatursensor 67c vorgesehen, der beispielsweise über einen Kanal 67d (vgl. in Fig. 4) in den Magazinträger 7a einführbar ist. Dieser Temperatursensor 67c ist beispielsweise ein Thermoelement oder noch ein temperaturempfindlicher Platinwiderstand und dergleichen. Über die Messung der Temperatur des Magazinträgers 7a ermöglicht der Temperatursensor 67c die Regelung der Temperatur des Magazins 7 und der zu behandelnden Systemträger.

Innerhalb des Gehäuses 1 befindet sich eine Heizung 8, durch die ein Gas im Innenraum I aufgeheizt werden kann. In dem in Fig. 1 gezeigten Ausbildungsbeispiel besteht die Heizung 8 aus zwei getrennt angeordneten horizontalachsigen Heizspiralen 8a und 8b, welche sich vor und hinter einem Ventilator 9 befinden. Der Ventilator 9 ist im Gehäuse 1 etwa in dessen vertikaler Mittelebene angeordnet und seine Flügel sind an einer horizontalen Welle 10 gelagert, welche in nur schematisch angedeuteten Lagerböcken 11 und 12 dreht. Die Welle 10 ist über eine Magnetkupplung 13 mit einem externen, nicht näher gezeigten Antrieb verbunden.

Es ist erkennbar, dass der Temperatursensor 67c durch den Magazinträger 7a vor einer direkten Wärmebestrahlung durch die Heizspiralen 8a und 8b der Heizung 8 abgeschirmt ist.

Zwischen Ventilator 9 und Magazin 7 ist noch ein Leitblech 14 vorgesehen, welches eine gewünschte Gasströmung gewährleistet.

Im Ausbildungsbeispiel gemäss Fig. 1 wird vom Ventilator 9 mit entsprechend angestellten Flügeln Gas von links angesogen, wobei dieses Gas durch die Heizspirale 8a streicht. Ferner drückt der Ventilator 9 das Gas nach rechts durch die andere Heizspirale 8b, wobei das Leitblech 14 einen Zwangsschacht 15 bildet, durch den der Gasstrom hindurchtreten muss. Danach durchzieht dieses erwärmte Gas das Magazin 7 und die darin angeordneten Systemträger, und es wird links wieder durch einen weiteren Zwangsschacht 16 in den Bereich oder Raum des Ventilators gesogen.

In der Praxis hat sich herausgestellt, dass das langsam durch das Magazin strömende Gas nur eine geringe Wärmekapazität aufweist, so dass eine erhebliche Wärmedifferenz an der Gaseintrittsseite gegenüber der Gasaustrittsseite besteht. Hierdurch erfolgt eine asymmetrische Behandlung der Systemträger, die nicht erwünscht ist. Dieser Nachteil kann dadurch ausgeglichen werden, dass der Ventilator 9 in bestimmten Zeitabständen seine Drehrichtung umkehrt, so dass die Gaseintrittsseite im Magazin 7 wechselt. Diese Umkehr der Drehrichtung kann wie bereits erwähnt beispielsweise mit einer Periodizität von 10 bis 30 Sekunden und vorzugsweise von 10 Sekunden erfolgen. Hierdurch wurden bereits wesentlich bessere Ergebnisse erzielt.

In einem weiteren Ausbildungsbeispiel gemäss Fig. 2 besteht in einer Box R₁ die Heizung 8 nur aus einer einzigen Heizspirale, welche zwischen einem Radialventilator 17-und dem Magazin 7 angeordnet ist. Zwischen Heizung 8 und Radialventilator 17 befindet sich noch ein geschlossener Gasleitstutzen 18, an dessen Seiten Kammerwände 19 und 20 anschliessen. Dem Radialventilator 17 ist ein Motor 24 zugeordnet.

Die Kammerwände 19 und 20 bilden zusammen mit Seitenwänden 3 und 4 und mit verstellbaren Klappen oder verschiebbaren Abschlussblechen 21a und 21b einen Innenraum I1. Dem Abschlussblech 21a ist eine Betätigungsvorrichtung 23a und dem Abschlussblech 21b eine Betätigungsvorrichtung 23b zugeordnet. Mit Hilfe dieser Betätigungsvorrichtungen 23a und 23b lassen sich die jeweiligen Abschlussbleche 21a und 21b zwischen zwei Lagen verschieben bzw. Klappen lassen sich zwischen zwei Lagen verstellen, bei denen sie den Innenraum I1 verschliessen bzw. einen jeweiligen Schacht 15a bzw. 15b für eine Gasströmung zum Magazin 7 freigeben. In der in Fig. 2 dargestellten Lage ist der Schacht 15a durch das Abschlussblech 21a verschlossen, während der Schacht 15b vom Abschlussblech 21b freigegeben wird. Somit gelangt vom Schacht 15a keine Gasströmung zum Magazin, während über den Schacht 15b ein Gasstrom zum Magazin 7 geführt wird. Dieser Gasstrom durchfliesst dann das Magazin 7 ganz oder teilweise und wird vom Radialventilator 17 durch den Gasleitstutzen 18 und die Heizung 8 hindurch wieder angesaugt. Analog zum vorangehenden und mit gleichartigen Gründen und Vorteilen kann die Betätigung der Abschlussbleche bzw. Klappen beispielsweise mit einer Periodizität von 10 bis 30 Sekunden, vorzugsweise von 10 Sekunden erfolgen, um die Gaseintrittsseite am Magazin 7 und die Richtung des Gasstroms durch das Magazin 7 alternierend zu wechseln.

In der Heizung 8 ist im übrigen ein zusätzlicher Temperaturfühler 65 perspektivisch angedeutet. Tatsächlich verläuft eine Rohrhülse 66 im wesentlichen koaxial mit der Heizung 8. Die Rohrhülse 66 dient als thermische Abschirmung und mechanischen Schutz für einen Temperatursensor 67, wobei entsprechende Anschlussfahnen 68 durch ein nur teilweise dargestelltes Röhrchen 69 aus dem Innenraum I₁ der Box R₁ herausgeführt werden. Die relativen Abmessungen der Rohrhülse 66 und der Heizspirale der Heizung 8 sind so gewählt, dass der Temperatursensor 67 durch die Rohrhülse 66 vor einer direkten Wärmebestrahlung durch die Heizspirale der Heizung 8 abgeschirmt ist. Der zusätzliche Temperaturfühler 65 liefert einen zusätzlichen Temperaturmesswert, mit welchen die Steuerung des räumlichen und zeitlichen Temperaturprofils in der Box R₁ weiter verbessert werden kann. Selbstverständlich kann ein solcher zusätzlicher Temperaturfühler 65 in jedem Ausbildungsbeispiel der vorliegenden Erfindung benutzt werden.

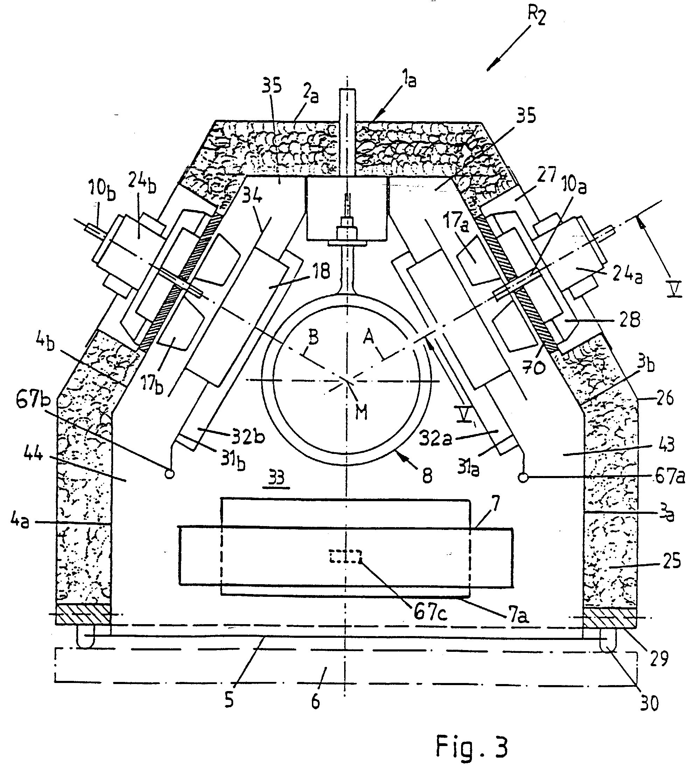

Bei dem in den Fig. 3 bis 5 gezeigten erfindungsgemässen Ausführungsbeispiel ist ein Gehäuse 1a einer Box R₂ mehreckig ausgebildet und dessen Wandteile sind mit wärmeisolierendem Material 25 gefüllt. Bei diesem Gehäuse 1a ist dessen Rückwand 2a weniger breit ausgebildet als dessen Beschickungsöffnung 5. Diese Beschickungsöffnung 5 wird von zwei etwa parallel verlaufenden Seitenwandstreifen 3a und 4a gebildet, an die sich Seitenwandstreifen 3b und 4b anschliessen, die über ein Knie 26 zur Rückwand 2a hin abgebogen sind. In diesen Seitenwandstreifen 3b und 4b sind Ausnehmungen 27 zur Aufnahme eines Motors 24a bzw. 24b vorgesehen, wobei jeder Motor 24a und 24b einen Radialventilator 17a und 17b im Inneren des Gehäuses 1a antreibt. Insbesondere aus Fig. 3 ist erkennbar, dass keiner der Motoren 24a und 24b aus der äusseren Ebene des Gehäuses 1a, welches durch die Aussenwand der Seitenstreifen 3a und 4a gebildet wird, herausragt. Damit können mehrere solcher Boxen R₂ nebeneinander und übereinander angeordnet werden, ohne einander durch die Anordnung der Motoren 24a und 24b ausserhalb der Boxen R₂ zu behindern.

Die Anordnung der Motoren 24a und 24b ausserhalb der Box R₂ hat sowohl für den Motor selbst als auch für die Lagerung einer Welle 10a, auf welcher der Radialventilator 17a bzw. 17b aufsitzt, erhebliche Vorteile. Gewünschtermassen bestehen innerhalb des Gehäuses 1a hohe Temperaturen, welche sich negativ auf einen Motor auswirken würden. Zur Störung des Betriebs genügt schon, dass sich die Welle 10a wesentlich erhitzt. Im vorliegenden Ausbildungsbeispiel kann einer derartigen heissen Lagerung durch entsprechende Isoliermassnahmen wie Halterungen 28 für den Motor 24a bzw. 24b entgegengewirkt werden.

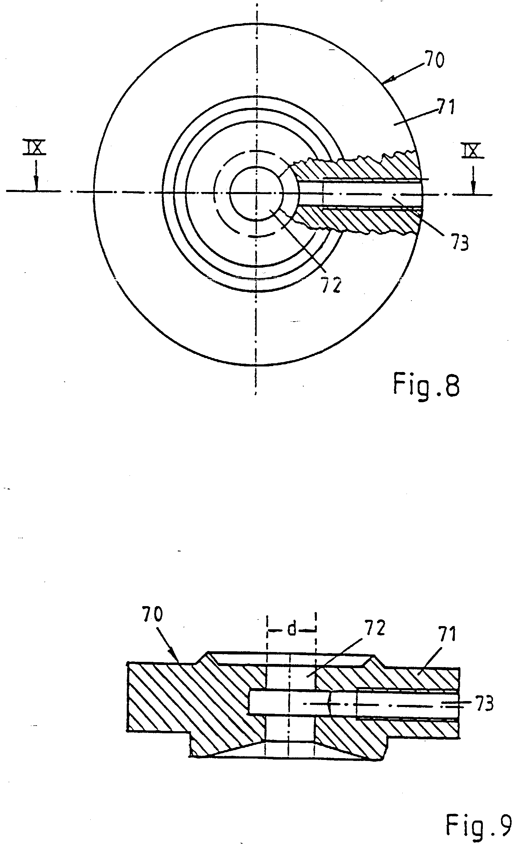

Ein bevorzugtes Ausbildungsbeispiel einer Wellendichtung ist in den Fig. 8 und 9 gezeigt. Eine derartige Wellendichtung 70 besteht aus einer Ringscheibe 71, welche etwa in ihrer Mitte eine Wellendurchführung 72 aufweist. Der Durchmesser d der Wellendurchführung 72 ist grösser als der Durchmesser der Welle 10a. Hierdurch ist die Welle 10a in der Wellendichtung 70 mit Spiel gelagert. In die Wellendurchführung 72 mündet eine Radialleitung 73 ein, über welche ein Schutzgas, beispielsweise Stickstoff, in die Wellendurchführung 72 eingeleitet wird. Dieses Gas umspült die Welle 10a und bewirkt eine Abdichtung des Innenraums der Box R₂ nach aussen wie auch nach innen. Zudem bewirkt diese Umspülung der Welle 10a ihre Kühlung durch das Gas. Entsprechende Zuführleitung für das Gas sind nicht näher gezeigt. Somit kann die Welle 10a das Gehäuse der Box R₂ ohne Reibung durchqueren und es wird dennoch keine Undichtigkeit des Gehäuses 1a der Box R₂ verursacht, durch welche das Gas von aussen her mit Luft und Staub verunreinigt werden könnte.

Ergänzend sei noch zu bemerken, dass die Stirnkanten 29 der Seitenwandstreifen 3a und 4a mit einer entsprechenden Ringdichtung 30 belegt sind. Es ist aus den nachfolgend angegebenen Gründen wesentlich, dass der Innenraum des Gehäuses la hermetisch abgeschlossen bleibt. Bei der Polymerisation von Epoxyharzen werden Stoffe freigesetzt, so dass das Gas aus der Box nicht ohne Reinigung oder dergleichen an die Umwelt abgegeben werden sollte. Ferner ist es wichtig, dass die Behandlung der Systemträger so staubfrei wie möglich erfolgt. Zudem wird in der Regel ein später beschriebener Zustrom von Stickstoff zugesetzt, um eine unerwünschte Oxidation zu verhindern.

Im Inneren des Gehäuses la verlaufen etwa parallel zu den schräggeneigten Seitenwandstreifen 3b und 4b jeweilige Wände 31a und 31b, welche sich über entsprechende Bleche 32a und 32b gegen einen Boden 33 des Gehäuses abstützen. In jede dieser Wände 31a und 31b ist je ein Gasleitstutzen 18 der bereits oben bei einem anderen Ausbildungsbeispiel erwähnten Art eingesetzt, welcher mit dem entsprechenden Radialventilator 17a bzw. 17b zusammenwirkt. Vorteilhafterweise ist dem Gasleitstutzen 18 noch ein Ringflansch 34 angeformt, welcher unter anderem als Leitblech dient und ein Rückströmen des angesaugten Gases in den Gasleitstutzen 18 verhindert.

Da die Wand 31 bis zur Rückwand 2a verläuft, bildet sich zwischen Radialventilator 17 und Rückwand 2a ein Raum 35, der nur zum Radialventilator 17 hin offen ist. Ansonsten kann hier keine Gasströmung in eine andere Richtung erzeugt werden.

Zwischen den beiden schräg zueinander angeordneten Wänden 31a und 31b ist die Heizung 8 als aufrecht stehende Heizspirale angeordnet, deren Wendelachse M im wesentlichen orthogonal zu jeweiligen Längsachsen A, B der Ausgangsstutzen 18 angeordnet ist. Vorzugsweise schneiden sich Längsachse A und Längsachse B der Wellen 10a und 10b der Motoren 24a und 24b in einem Mittelpunkt M der Heizung 8 bzw. auf der Wendelachse M der entsprechenden Heizspirale. Die Achsen A und B bilden im übrigen auch eine Mittelachse für den jeweiligen Gasleitstutzen 18.

In Fig. 4 ist erkennbar, dass die Heizung 8 über entsprechende Anschlussleitungen 36 mit einer nicht näher gezeigten Energiequelle in Verbindung steht. Ferner sind in Fig. 4 auch eine Zuführleitung 38 und eine Abführleitung 39 erkennbar, die im Inneren des Gehäuses la nahe einem Boden 33 bzw. einer Decke 40 ausmünden, wobei die Verteilung des zugeführten Gases bzw. die Sammlung des abzuführenden Gases durch eine Verteilerscheibe 41 bzw. eine Sammelscheibe 42 unterstützt wird. Zugeführt wird beispielsweise vorgewärmter Stickstoff. Abgeführt wird vor allem ein Gas, das mit bei der Polymerisation von Epoxyharzen freiwerdenden Stoffen geladen ist.

Der wesentliche Vorteil der vorliegenden Anordnung liegt zum einen darin, dass eine möglichst geringe Gasumlenkung stattfindet. Eine Gasumlenkung hat immer einen unerwünschten Druckabfall zur Folge, so dass möglichst wenig Umlenkungen stattfinden sollen. Im vorliegenden Ausbildungsbeispiel wirkt sich die geringfügige Gasumlenkung im Knie 26 bzw. in Führungsschächten 43 und 44 zwischen Wand 31a und Seitenwandstreifen 3a bzw. Wand 31b und Seitenwandstreifen 4a kaum merklich auf den Druck der Strömung aus. Das Gas muss dann nur zum Eintritt in das Magazin 7 jeweils von beiden Seiten her umgelenkt werden. Dies kann gegebenenfalls noch durch nicht näher gezeigte seitliche Schikanen vor dem Magazin 7 verbessert werden.

Vom Erfindungsgedanken ist auch umfasst, dass die Motoren 24a und 24b statt gleichsinnig auch gegensinnig drehen können, wodurch allerdings eine Gasströmung auf beiden Seiten des Magazins 7 entweder im oberen oder im unteren Bereich verstärkt wird, während in dem jeweils anderen Bereich die Gasströmung vermindert ist. Dies resultiert aus folgender Überlegung:

Dreht beispielsweise der Radialventilator 17a im Uhrzeigersinn, so wird Gas durch die untere Hälfte des Flügelrads des Radialventilators 17a nach hinten in die Kammer 35 bzw. gegen die Rückwand 2a geschleudert. Ein Ausbringen von Gas durch den Führungsschacht 43 erfolgt dagegen durch den oberen Teil des Flügelrads des Radialventilators 17a. Damit wird die Gasströmung im oberen Gehäusebereich beschleunigt, so dass auch eine Strömung an den oben gelagerten Systemträgern im Magazin 7 verstärkt ist. Gleiches gilt auch für den Radialventilator 17b, sofern dessen Motor 24b gegen den Uhrzeigersinn dreht. Damit treffen im oberen Bereich des Magazins 7 zwei verstärkte Gasströme aufeinander, während der untere Bereich des Magazins im wesentlichen vernachlässigt ist.

Aus diesem Grund sollen bevorzugt beide Motoren 24a und 24b gleichsinnig drehen. Hierdurch wird gewährleistet, dass in einem oberen Bereich der Box R₂ höhere Geschwindigkeiten der Gasströmungen in der einen Durchflussrichtung (Ventilator 17a mit Motor 24a) von etwas geringeren Geschwindigkeiten der Gasströmungen in der anderen Durchflussrichtung (Ventilator 17b mit Motor 24b) kompensiert werden, während das Umgekehrte in einem unteren Bereich der Box R₂ gilt. In der Box R₂ entsteht somit ein System von Gasströmen, welches, durch die vertikale Beschickungsöffnung 5 hindurch betrachtet, eine Symmetrie um das Zentrum und die Diagonalen (nicht jedoch die Mittellinien) der rechteckigen Beschickungsöffnung 5 zu haben scheint.

Auch hier führt eine periodische Umkehr der Drehrichtung der Motoren zu einer wechselnden Verteilung des Gasstromes in der Box R₂ und somit zu einer Verbesserung der Behandlung der Systemträger. Analog zum vorangehenden und mit gleichartigen Gründen und Vorteilen kann diese gemeinsame Umkehr der Drehrichtung der beiden Ventilatoren beispielsweise mit einer Periodizität von 10 bis 30 Sekunden, vorzugsweise von 10 Sekunden erfolgen, um die Richtung und Verteilung des Gasstroms durch das Magazin 7 alternierend zu wechseln.

Wie bei den vorangehend beschriebenen Ausbildungen ist auch hier in der Box R₂ ein Magazinträger 7a vorgesehen, auf dem ein Magazin 7 in etwa vor der Beschickungsöffnung 5 zentriert aufgestellt und somit in mittlerer Höhe der Box R₂ angeordnet ist, damit es gleichmässiger vom Gasstrom beaufschlagt wird. Auch hier ist der Magazinträger 7a mit dem Magazin 7 thermisch möglichst gut gekoppelt, aber vom Gehäuse 1 bzw. von dessen Boden 33 über die Zwischenschicht 7b (vgl. in Fig. 4) thermisch entkoppelt, und auch hier ist im wesentlichen im Zentrum des Magazinträgers 7a und thermisch damit gekoppelt ein Temperatursensor 67c vorgesehen, der über einen Kanal 67d (vgl. in Fig. 4) in den Magazinträger 7a einführbar ist, um über die Messung der Temperatur des Magazinträgers 7a die Regelung der Temperatur des Magazins 7 und der zu behandelnden Systemträger zu ermöglichen. Dabei ist der Temperatursensor 67c durch den Magazinträger 7a vor einer direkten Wärmebestrahlung durch die Heizspirale der Heizung 8 abgeschirmt.

Zusätzlich zum Temperatursensor 67c sind in der Box R₂ zwei Gastemperaturfühler 67a und 67b (vgl. in Fig. 3) vorgesehen, die beide in mittlerer Höhe der Box R₂ und somit relativ zueinander im wesentlichen in gleicher Höhe etwa am Ende der Wände 31a und 31b angeordnet sind, um die Temperatur der jeweiligen Gasströme in den Führungsschächten 43 und 44 zu fühlen. Es kann auch mehr als ein solches Paar von Gastemperaturfühlern vorgesehen werden (vgl. in Fig. 4), beispielsweise sechs Gastemperaturfühler (von denen nur die drei linksseitigen Gastemperaturfühler 67b', 67b" und 67b"' in Fig. 4 sichtbar sind). Solche Gastemperaturfühler sind dann paarweise relativ zueinander im wesentlichen in gleicher Höhe in der Box R₂ beispielsweise auch am Ende der Wände 31a und 31b angeordnet. Diese zusätzlichen Gastemperaturfühler 67a und 67b erlauben, über deren Temperatur die Symmetrie der Gasströme in der Box R₂ zu erfassen und somit die Symmetrie des Betriebs der Box R₂ zu kontrollieren. Auf diese Weise kann die Einhaltung des Temperaturprofils an den Bauteilen im Magazin am besten erfasst und optimal überwacht werden.

Es versteht sich, dass solche Gastemperaturfühler auch im Zusammenhang mit anderen Ausbildungen der Erfindung eingesetzt werden können, beispielsweise um über deren Temperatur die Symmetrie der Gasströme in Zwangsschächten 15 und 16 (Fig. 1) oder in Zwangsschächten 15a und 15b (Fig. 2) zu erfassen.

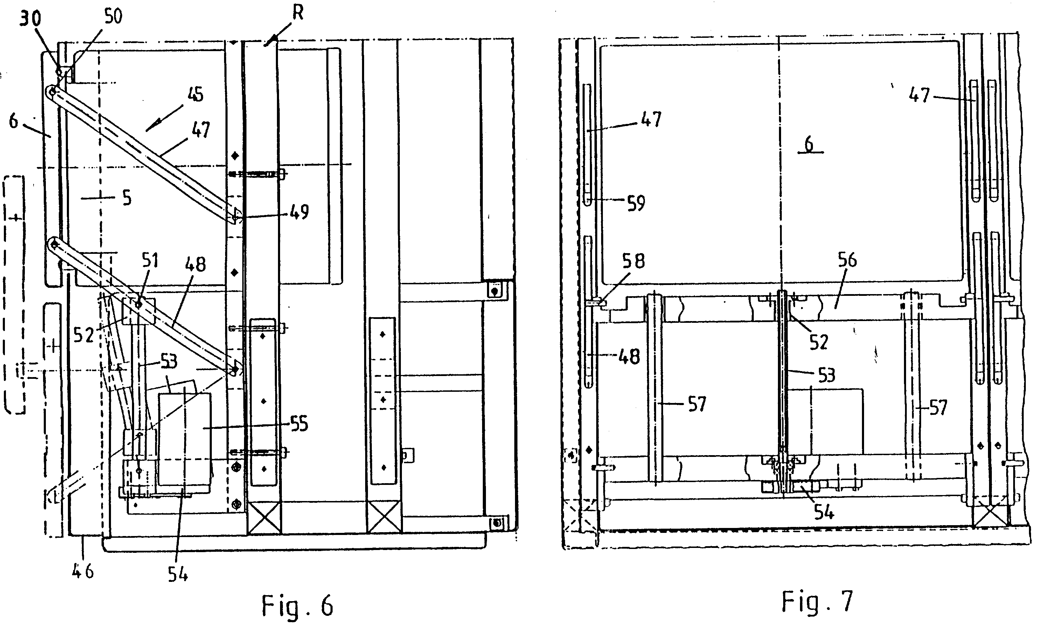

Einem automatischen Beschicken der Box R ist es förderlich, wenn die Tür 6 vollautomatisch geöffnet und gänzlich aus dem Bereich der Beschickungsöffnung 5 entfernt werden kann. Hierzu ist gemäss den Fig. 6 und 7 eine Parallelogrammführung 45 vorgesehen, mittels welcher die Tür 6 weg von der Beschickungsöffnung 5 in eine Endlage unterhalb der Beschickungsöffnung 5 nahe an ein Hauptgehäuse 46 der Aushärtungsanlage verbracht werden kann. Diese Endlage sowie eine Zwischenstation sind in Fig. 6 gestrichelt angedeutet.

Die Parallelogrammführung 45 weist zwei parallel angeordnete Hebel 47 und 48 auf, welche einerseits ein ortsfestes Drehgelenk 49 mit der Box R₂ oberhalb des Hauptgehäuses 46 bilden, während sie andererseits über ein weiteres Drehgelenk 50 mit der Tür 6 verbunden sind.

Die Hebel 48 sind über Drehbolzen 51 mit einer Traverse 56 verbunden, in der eine Hülse 52 lagert, welche ein nicht näher gezeigtes Innengewinde aufweist. Dieses Innengewinde kämmt eine Spindelstange 53, welche drehbar gelagert ist und beispielsweise über einen Antriebsriemen 54 mit einem Motor 55 in Verbindung steht. Die gesamte Antriebsanordnung ist kippbar gelagert, so dass der Bewegung der Parallelogrammführung 45 Rechnung getragen werden kann, wie dies auch gestrichelt dargestellt ist.

In Fig. 7 ist erkennbar, dass die Traverse 56 entlang von Führungssäulen 57 gleiten kann. Seitlich ist die Traverse 56 über entsprechende Bolzen 58 mit dem unteren Hebel 48 verbunden, wobei sowohl Hebel 48 wie auch 47 sich in Langlöcher 59 in dem Hauptgehäuse 46 bewegen. In Fig. 7 ist rechts angedeutet, dass neben der einen Box gleich eine weitere Box angesetzt sein kann.

Mit Hilfe dieser Parallelogrammführung ist die Tür 6 relativ zur Beschickungsöffnung 5 bewegbar, wobei die Tür 6 stets parallel zur Ebene der Beschickungsöffnung 5 und somit zur Dichtung 30 bleibt. Beim Schliessen der Box wird deshalb die Dichtung 30 überall gleichzeitig und gleichmässig zwischen der Box und der Tür zusammengedrückt und beansprucht, was den Verschleiss der Dichtung vermindert und somit die Abdichtung verbessert sowie eine längere Betriebstüchtigkeit der Dichtung gewährleistet.

## Patentansprüche

1. Aushärteofen zur Wärmebehandlung mindestens eines im wesentlichen quaderförmigen Magazins (7) für, zu einer horizontalen Längsrichtung des Magazins parallele, mit elektronischen Bauelementen (sogenannten Chips) bestückte, Systemträger (sogenannte Leadframes) in zumindest einer Box (R₁, R₂), die ein Gehäuse (1a) mit einer von Stirnkanten (29) definierten und von einer Tür (6) verschliessbaren Beschickungsöffnung (5) aufweist und in welcher ein Ventilator (17, 17a, 17b) zum Beaufschlagen der Systemträger im Magazin mit einem heissen Gas vorhanden sowie mindestens ein Gasleitelement angeordnet ist, **dadurch gekennzeichnet, dass** das Gasleitelement ortsfest ist, dass ein zweiter Ventilator (17, 17a, 17b) vorgesehen ist, wobei beide Ventilatoren (17, 17a, 17b) am Gehäuse (1a) abgestützt und darin so angeordnet sind, dass sie im Bereich des Magazins (7) mindestens einen im wesentlichen horizontal und im wesentlichen parallel zu der Längsrichtung des Magazins gerichteten Gasstrom erzeugen, und dass die Richtung des Gasstromes durch die Ventilatoren umkehrbar ist.

2. Aushärteofen nach Anspruch 1, **dadurch gekennzeichnet, dass** die Ventilatoren (9, 17, 17a, 17b) drehrichtungsumkehrbar sind.

3. Aushärteofen nach Anspruch 1, **dadurch gekennzeichnet, dass** eine Heizung (8) vorhanden ist, die sich auf einer im wesentlichen horizontalen Strecke (15, 16, 15a, 15b, 43, 44) eines vom Magazin (7) zum Ventilator (9, 17, 17a, 17b) oder vom Ventilator zum Magazin führenden Gasstrom befindet.

4. Aushärteofen nach Anspruch 3, dadurch gekennzeichnet, dass die Heizung (8) zweiteilig ist und sich je ein Teil (8a, 8b) der Heizung (8) auf den jeweiligen Strecken (15, 16) der vom Magazin (7) zum Ventilator (9) und vom Ventilator zum Magazin führenden Gasströme befindet.

5. Aushärteofen nach Anspruch 1, dadurch gekennzeichnet, dass mindestens ein vorzugsweise als Leitblech, Wand, Gasleitstutzen und dergleichen ausgebildetes Gasleitelement (14, 18, 19, 20, 31, 31a, 31b) zwischen den Ventilatoren (9, 17, 17a, 17b) und dem Magazin (7) angeordnet ist.

6. Aushärteofen nach Anspruch 5, dadurch gekennzeichnet, dass einer der Ventilatoren (9) als Schraubenventilator mit einer zur Längsrichtung des Magazins (7) im wesentlichen parallelen Richtung seiner Welle (10) und seines Gasausstosses ausgebildet ist, und das Gasleitelement als Leitblech (14) ausgebildet ist, welches zwischen dem Magazin (7) und dem Ventilator (9) sitzt und zusammen mit Seitenwänden (3, 4) des Gehäuses (1) der Box (R) Zwangsschächte (15, 16) ausbildet.

7. Aushärteofen nach Anspruch 5, dadurch gekennzeichnet, dass durch als Gasleitelemente wirkende Kammerwände (19, 20) im Anschluss an den Ventilator (17) mindestens ein Schacht (15a, 15b) ausgebildet ist, der einen Gasstrom den im Magazin (7) angeordneten Systemträgern einseitig zuleitet.

8. Aushärteofen nach Anspruch 5, dadurch gekennzeichnet, dass durch zumindest ein als Gasleitelement wirkendes Leitblech (14) bzw. eine als Gasleitelement wirkende Wand (19, 20; 31a, 31b) zwei Zwangsschächte (15, 16; 15a, 15b) bzw. Führungsschächte (43, 44) ausgebildet sind, durch welche je ein Gasstrom vom Magazin (7) zu einem Ventilator (17, 17a, 17b) bzw. von einem Ventilator zum Magazin führbar ist.

9. Aushärteofen nach Anspruch 8, dadurch gekennzeichnet, dass die Ventilatoren (17a, 17b) als Radialventilatoren ausgebildet sind und das Magazin (7) in jeweils entgegengesetzte Richtungen mit Gas beaufschlagen.

10. Aushärteofen nach Anspruch 9, dadurch gekennzeichnet, dass jedem Ventilator (17a, 17b) ein vorzugsweise mit einem Ringflansch (34) versehener Gasleitstutzen (18) zugeordnet ist, wobei dieser Gasleitstutzen (18) in einer Wand (31a, 31b) sitzt, die an eine Rückwand (2a) der Box (R₂) anschliesst und zum Magazin (7) hin einen Führungsschacht (43, 44) ausbildet.

11. Aushärteofen nach Anspruch 10, dadurch gekennzeichnet, dass die Heizung (8) als Heizspirale ausgebildet und zwischen den Gasleitstutzen (18) der beiden Ventilatoren (17a, 17b) angeordnet ist, wobei eine Wendelachse (M) der Heizspirale im wesentlichen vertikal und jeweilige Längsachsen (A, B) der Gasleitstutzen (18) im wesentlichen horizontal angeordnet ist.

12. Aushärteofen nach Anspruch 9, dadurch gekennzeichnet, dass die Ventilatoren (17a, 17b) mit jeweiligen Motoren (24a, 24b) versehen und damit über Wellen (10a, 10b) verbunden sind, wobei die Motoren (24a, 24b) jeweils ausserhalb des Gehäuses (1a) der Box (R₂) angeordnet sind, gleichsinnig drehen und auf etwa gegenüberliegenden Seitenwandstreifen (3b, 4b) des Gehäuses (1a) angeordnet sind.

13. Aushärteofen nach Anspruch 12, dadurch gekennzeichnet, dass die im wesentlichen vertikalen Seitenwandstreifen (3b, 4b) schräg von einer im wesentlichen vertikalen Rückwand (2a) des Gehäuses (1a) der Box (R₂) weg verlaufen, wobei diese Rückwand (2a) schmaler ist als die im wesentlichen vertikale Beschickungsöffnung (5) der Box (R₂).

14. Aushärteofen nach Anspruch 11 und 13, dadurch gekennzeichnet, dass jeweils ein Gasleitstutzen (18) und eine Welle (10a, 10b) im wesentlichen kongruente Längsachsen (A, B) aufweisen, die sich im wesentlichen im Mittelpunkt (M) der Heizspirale bzw. auf deren Wendelachse (M) treffen.

15. Aushärteofen nach Anspruch 14, dadurch gekennzeichnet, dass die Längsachsen (A, B) einen stumpfen Winkel einschliessen, so dass die Ventilatoren (17a, 17b) schräg zueinander geneigt angeordnet sind.

16. Aushärteofen nach Anspruch 1, dadurch gekennzeichnet, dass in der Box (R, R₁, R₂) ein vom Gehäuse (1, 1a) thermisch entkoppelter Magazinträger (7a) vorgesehen ist, auf dem mindestens ein Magazin (7) in einer in etwa vor der Beschickungsöffnung (5) zentrierten Lage abstützbar ist.

17. Aushärteofen nach Anspruch 16, dadurch gekennzeichnet, dass ein Temperatursensor (67c) in wesentlichen im Zentrum des Magazinträgers (7a) und thermisch damit gekoppelt angeordnet ist, wobei der Magazinträger den Temperatursensor vor einer direkten Wärmebestrahlung durch die Heizspirale der Heizung (8) abschirmt.

18. Aushärteofen nach den Ansprüchen 8 und 17, dadurch gekennzeichnet, dass in der Box zusätzlich zum Temperatursensor (67c) mindestens zwei Gastemperaturfühler (67a, 67b) vorgesehen sind, die relativ zueinander im wesentlichen in gleicher Höhe angeordnet sind und von denen jeweils mindestens einer dem Gasstrom je eines der beiden Zwangsschächte (15, 16) bzw. Führungsschächte (43, 44) zugeordnet ist, um dessen Temperatur zu fühlen.

19. Aushärteofen nach Anspruch 1, dadurch gekennzeichnet, dass Ventilatoren (9) jeweils als Schraubenventilator mit einer zur Längsrichtung des Magazins (7) im wesentlichen parallelen Richtung ihrer Welle (10) und ihres Gasausstosses ausgebildet sind, und diese Wellen (10) über eine Magnetkupplung (13) mit einem ausserhalb der Box (R) angeordnetem Antrieb verbunden sind.

20. Aushärteofen nach Anspruch 1, dadurch gekennzeichnet, dass eine mit einem ausserhalb der Box angeordneten Antrieb oder Motor verbundene Welle (10a, 10b) des jeweiligen Ventilators (17, 17a, 17b) eine am Gehäuse (1a) angeordnete Wellendichtung (70) durchfährt, die eine Wellendurchführung (72) aufweist, welche einen grösseren Durchmesser (d) hat als denjenigen der Welle (10a, 10b) und in welche eine Radialleitung (73) zur Zuführung eines Gases, vorzugsweise eines Schutzgases wie Stickstoff, einmündet.

21. Aushärteofen nach Anspruch 1, dadurch gekennzeichnet, dass die Tür (6) über eine Parallelogrammführung (45) mit einem die Box (R) abstützenden Hauptgehäuse (46) verbunden ist.

22. Aushärteofen nach Anspruch 21, dadurch gekennzeichnet, dass die Parallelogrammführung (45) aus jeweils zwei gelenkig mit den Seiten der Tür (6) und dem Hauptgehäuse (46) verbundenen Hebeln (47, 48) besteht, welche von einem Antrieb bewegbar sind.

23. Aushärteofen nach Anspruch 22, dadurch gekennzeichnet, dass zwischen zwei Hebeln (48) eine im wesentlichen horizontale Traverse (56) angeordnet ist, in der eine Hülse (52) mit einem Innengewinde sitzt, welches von einer ortsfesten Spindelstange (53) durchsetzt ist.

24. Aushärteofen nach Anspruch 23, dadurch gekennzeichnet, dass die Spindelstange (53) über einen Antriebsriemen (54) mit einem Motor (55) verbunden ist.

25. Aushärteofen nach Anspruch 1, dadurch gekennzeichnet, dass der Ventilator als Schraubenventilator (9) ausgebildet ist und die Richtung des Gasstromes durch Umkehr der Drehrichtung des Ventilators änderbar ist.

26. Aushärteofen nach Anspruch 8, dadurch gekennzeichnet, dass eine Verteilung des Gasstromes in der Box (R₂) durch gleichzeitige Umkehr der Drehrichtung der beiden Ventilatoren (17a, 17b) periodisch änderbar ist.

## Claims

1. Curing oven for the heat treatment of at least one essentially cuboidal magazine (7) for lead frames, which are parallel to a horizontal longitudinal direction of the magazine and are fitted with electronic chips, in at least one box (R1, R2) which has a housing (1a) with a charging opening (5) which is defined by end edges (29) and can be closed by a door (6), and in which box a fan (17, 17a, 17b) is present for subjecting the lead frames in the magazine to a hot gas and at least one gas-conducting element is arranged, characterized in that the gas-conducting element is stationary, in that a second fan (17, 17a, 17b) is provided, the two fans (17, 17a, 17b) being supported on the housing (1a) and being arranged therein in such a way that they generate in the region of the magazine (7) at least one gas stream directed essentially horizontally and essentially parallel to the longitudinal direction of the magazine, and in that the direction of the gas stream can be reversed by the fans.

2. Curing oven according to Claim 1, characterized in that the direction of rotation of the fans (9, 17, 17a, 17b) can be reversed.

3. Curing oven according to Claim 1, characterized in that a heater (8) is present which is located on an essentially horizontal section (15, 16, 15a, 15b, 43, 44) of a gas stream leading from the magazine (7) to the fan (9, 17, 17a, 17b) or from the fan to the magazine.

4. Curing oven according to Claim 3, characterized in that the heater (8) is of two parts and one part (8a, 8b) of the heater (8) is in each case located on the respective sections (15, 16) of the gas streams leading from the magazine (7) to the fan (9) and from the fan to the magazine.

5. Curing oven according to Claim 1, characterized in that between the fans (9, 17, 17a, 17b) and the magazine (7) there is arranged at least one gas-conducting element (14, 18, 19, 20, 31, 31a, 31b), preferably designed as a baffle, wall, gas-conducting branch and the like.

6. Curing oven according to Claim 5, characterized in that one of the fans (9) is designed as a helical fan with its shaft (10) and its gas expulsion in a direction essentially parallel to the longitudinal direction of the magazine (7), and the gas-conducting element is designed as a baffle (14) which is arranged between the magazine (7) and the fan (9) and together with side walls (3, 4) of the housing (1) of the box (R) forms forced-flow ducts (15, 16).

7. Curing oven according to Claim 5, characterized in that at least one duct (15a, 15b) is formed by chamber walls (19, 20) acting as gas-conducting elements adjoining the fan (17), which duct conducts a gas stream on one side to the lead frames arranged in the magazine (7).

8. Curing oven according to Claim 5, characterized in that two forced-flow ducts (15, 16; 15a, 15b) or guide ducts (43, 44) are formed by at least one baffle (14) acting as a gas-conducting element or at least one wall (19, 20; 31a, 31b) acting as a gas-conducting element, by which ducts a gas stream can in each case be guided from the magazine (7) to a fan (17, 17a, 17b) or from a fan to the magazine.

9. Curing oven according to Claim 8, characterized in that the fans (17a, 17b) are designed as radial fans and subject the magazine (7) to gas in respectively opposed directions.

10. Curing oven according to Claim 9, characterized in that each fan (17a, 17b) is assigned a gas-conducting branch (18), preferably provided with an annular flange (34), this gas-conducting branch (18) being seated in a wall (31a, 31b) which adjoins a rear wall (2a) of the box (R2) and forms a guide duct (43, 44) towards the magazine (7) .

11. Curing oven according to Claim 10, characterized in that the heater (8) is designed as a heating spiral and is arranged between the gas-conducting branches (18) of the two fans (17a, 17b), a helix axis (M) of the heating spiral being arranged essentially vertically and the respective longitudinal axes (A, B) of the gas-conducting branches (18) being arranged essentially horizontally.

12. Curing oven according to Claim 9, characterized in that the fans (17a, 17b) are provided with respective motors (24a, 24b) and are connected thereto by means of shafts (10a, 10b), the motors (24a, 24b) respectively being arranged outside the housing (la) of the box (R2), rotating in the same sense and being arranged on approximately opposite side wall strips (3b, 4b) of the housing (1a).

13. Curing oven according to Claim 12, characterized in that the essentially vertical side wall strips (3b, 4b) run obliquely away from an essentially vertical rear wall (2a) of the housing (1a) of the box (R2), this rear wall (2a) being narrower than the essentially vertical charging opening (5) of the box (R2).

14. Curing oven according to Claims 11 and 13, characterized in that in each case a gas-conducting branch (18) and a shaft (10a, 10b) have essentially congruent longitudinal axes (A, B) which meet essentially at the centre point (M) of the heating spiral or on the helix axis (M) of the latter.

15. Curing oven according to Claim 14, characterized in that the longitudinal axes (A, B) form an obtuse angle, so that the fans (17a, 17b) are arranged obliquely inclined with respect to each other.

16. Curing oven according to Claim 1, characterized in that in the box (R, R1, R2) there is provided a magazine carrier (7a) which is thermally isolated from the housing (1, 1a) and on which at least one magazine (7) can be supported in a position centred approximately in front of the charging opening (5).

17. Curing oven according to Claim 16, characterized in that a temperature sensor (67c) is arranged essentially at the centre of the magazine carrier (7a) and thermally coupled to it, the magazine carrier shielding the temperature sensor from direct heat irradiation by the heating spiral of the heater (8).

18. Curing oven according to Claims 8 and 17, characterized in that in the box there are provided in addition to the temperature sensor (67c) at least two gas-temperature sensors (67a, 67b) which are arranged in relation to each other at essentially the same height and of which in each case at least one is assigned to the gas stream of respectively one of the two forced-flow ducts (15, 16) or guide ducts (43, 44) in order to sense its temperature.

19. Curing oven according to Claim 1, characterized in that the fans (9) are in each case designed as a helical fan with their shaft (10) and their gas expulsion in a direction essentially parallel to the longitudinal direction of the magazine (7), and these shafts (10) are connected by means of a magnetic coupling (13) to a drive arranged outside the box (R).

20. Curing oven according to Claim 1, characterized in that a shaft (10a, 10b) of the respective fan (17, 17a, 17b) connected to a drive or motor arranged outside the box passes through a shaft seal (70) arranged on the housing (1a), the said shaft seal having a shaft gland (72) which has a greater diameter (d) than that of the shaft (10a, 10b) and into which there opens a radial line (73) for feeding in a gas, preferably an inert gas such as nitrogen.

21. Curing oven according to Claim 1, characterized in that the door (6) is connected by means of a parallelogram linkage (45) to a main housing (46) supporting the box (R).

22. Curing oven according to Claim 21, characterized in that the parallelogram linkage (45) comprises in each case two levers (47, 48) which are jointedly connected to the sides of the door (6) and to the main housing (46) and which can be moved by a drive.

23. Curing oven according to Claim 22, characterized in that between two levers (48) there is arranged an essentially horizontal crossmember (56), in which there is seated a sleeve (52) with an internal thread, through which a fixed spindle rod (53) passes.

24. Curing oven according to Claim 23, characterized in that the spindle rod (53) is connected by means of a drive belt (54) to a motor (55).

25. Curing oven according to Claim 1, characterized in that the fan is designed as a helical fan (9) and the direction of the gas stream is variable by reversing the direction of rotation of the fan.

26. Curing oven according to Claim 9, characterized in that distribution of the gas stream in the box (R2) is periodically variable by simultaneous reversal of the direction of rotation of the two fans (17a, 17b).

## Revendications

1. Four de durcissement pour le traitement thermique d'au moins un magasin (7) essentiellement parallélipipédique, pour des supports du système (ce que l'on appelle des "leadframes") parallèles à la direction longitudinale horizontale du magasin et chargés de constituants électroniques (ce que l'on appelle des "chips") dans au moins une boîte (R₁, R₂) qui présente un logement (1a) comprenant une ouverture de chargement (5) définie par des arêtes frontales (29) et qui peut être fermée par une porte (6) et dans lequel est présent un ventilateur (17, 17a, 17b) pour charger les supports du système dans le magasin avec un gaz chaud et dans lequel est disposé au moins un élément guidant le gaz, caractérisé en ce que l'élément guidant le gaz est monté à demeure, en ce qu'on prévoit un second ventilateur (17, 17a, 17b), les deux ventilateurs (17, 17a, 17b) s'appuyant contre le logement (1a) et y étant disposés de telle sorte qu'ils génèrent, dans la zone du magasin (7) au moins un courant de gaz orienté essentiellement à l'horizontale et essentiellement parallèlement à la direction longitudinale du magasin et en ce que, la direction du courant de gaz peut être inversée via les ventilateurs.

2. Four de durcissement selon la revendication 1, caractérisé en ce que les ventilateurs (9, 17, 17a, 17b) peuvent être inversés quant à leur sens de rotation.

3. Four de durcissement selon la revendication 1, caractérisé en ce qu'un chauffage (8) est présent, qui se trouve sur un tronçon essentiellement horizontal (15, 16, 15a, 15b, 43, 44) d'un courant de gaz menant du magasin (7) aux ventilateurs (9, 17, 17a, 17b) ou du ventilateur au magasin.

4. Four de durcissement selon la revendication 3, caractérisé en ce que le chauffage (8) est réalisé en deux parties, une partie (8a, 8b) du chauffage (8) se trouvant respectivement sur les tronçons respectifs (13, 16) des courants de gaz menant du magasin (7) au ventilateur (9) et du ventilateur au magasin.

5. Four de durcissement selon la revendication 1, caractérisé en ce qu'au moins un élément (14, 18, 19, 20, 31, 31a, 31b) guidant le gaz est disposé entre les ventilateurs (9, 17, 17a, 17b) et le magasin (7) et est réalisé de préférence en forme de déflecteur, de paroi, de tubulure guidant le gaz et analogues.

6. Four de durcissement selon la revendication 5, caractérisé en ce qu'un des ventilateurs (9) est réalisé sous forme de ventilateur fileté dont la direction l'arbre (10) et du rejet de gaz s'étend essentiellement parallèlement à la direction longitudinale du magasin (7), et l'élément guidant le gaz est réalisé en forme de déflecteur (14) qui vient se loger entre le magasin (7) et le ventilateur (9) et qui forme des gaines à circulation forcée (15, 16) conjointement avec les parois latérales (3, 4) du logement (1) de la boîte (R).

7. Four de durcissement selon la revendication 5, caractérisé en ce qu'au moins une gaine (15a, 15b) est réalisée via les parois de chambre (19, 20) se raccordant au ventilateur (17) et faisant office d'éléments guidant le gaz, qui amène unilatéralement un courant de gaz aux supports du système disposés dans le magasin (7).

8. Four de durcissement selon la revendication 5, caractérisé en ce que, deux gaines à circulation forcée (15, 16; 15a, 15b) respectivement deux gaines de guidage (43, 44) sont réalisées à l'aide d'au moins un déflecteur (14) faisant office d'élément guidant le gaz, respectivement d'au moins une paroi (19, 20; 31a, 31b) faisant office d'éléments guidant le gaz, à travers lesquelles on peut guider respectivement un courant de gaz du magasin (7) à un ventilateur (17, 17a, 17b) respectivement d'un ventilateur au magasin.

9. Four de durcissement selon la revendication 8, caractérisé en ce que, les ventilateurs (17a, 17b) sont réalisés sous forme de ventilateurs radiaux et chargent le magasin (7) avec du gaz dans des directions respectivement opposées.

10. Four de durcissement selon la revendication 9, caractérisé en ce qu'à chaque ventilateur (17a, 17b) est attribuée une tubulure (18) guidant le gaz munie de préférence d'une bride annulaire (34), cette tubulure (18) guidant le gaz étant logée dans une paroi (31a, 31b) qui se raccorde à une paroi dorsale (2a) de la boîte (R₂) et qui forme une gaine de guidage (43, 44) en direction du magasin (7).

11. Four de durcissement selon la revendication 10, caractérisé en ce que le chauffage (8) est réalisé en forme de spirale de chauffage et est disposé entre la tubulure (18) des deux ventilateurs (17a, 17b) guidant le gaz, l'axe hélicoïdal (M) de la spirale de chauffage étant disposé essentiellement à la verticale et les axes longitudinaux respectifs (A, B) des tubulures (18) guidant le gaz étant disposées essentiellement à l'horizontale.

12. Four de durcissement selon la revendication 9, caractérisé en ce que les ventilateurs (17a, 17b) sont munis de moteurs respectifs (24a, 24b) auxquels ils sont reliés via des arbres (10a, 10b), dans lequel les moteurs (24a, 24b) sont disposés respectivement à l'extérieur du logement (la) de la boîte (R₂), tournent dans le même sens et sont disposés sur des bandes (3b, 4b) de la paroi latérale du logement (1a) approximativement opposées.

13. Four de durcissement selon la revendication 12, caractérisé en ce que, les bandes de paroi latérales (3b, 4b) essentiellement verticales s'étendent en oblique en s'écartant de la paroi dorsale (2a) essentiellement verticale du logement (1a) de la boîte (R₂), cette paroi dorsale (2a) étant plus étroite que l'ouverture de chargement (5) essentiellement verticale de la boîte (R₂).

14. Four de durcissement selon les revendications 11 et 13, caractérisé en ce que, respectivement, une tubulure (18) guidant le gaz et un arbre (10a, 10b) présentent des axes longitudinaux (A, B) essentiellement congrus qui se rencontrent essentiellement au centre (M) de la spirale de chauffage, respectivement sur leur axe hélicoïdal (M).

15. Four de durcissement selon la revendication 14, caractérisé en ce que, les axes longitudinaux (A, B) forment un angle obtus si bien que les ventilateurs (17a, 17b) sont disposés en oblique en étant inclinés l'un par rapport à l'autre.

16. Four de durcissement selon la revendication 1, caractérisé en ce qu'on prévoit, dans la boîte (R, R₁, R₂), un support de magasin (7a) découplé du logement (1, 1a) par voie thermique, sur lequel peut venir s'appuyer au moins un magasin (7) dans une position approximativement centrée devant l'ouverture de chargement (5).

17. Four de durcissement selon la revendication 16, caractérisé en ce qu'un capteur de température (67c) est disposé essentiellement au centre du support de magasin (7a) en étant couplé à ce dernier par voie thermique, le support de magasin conférant au capteur de température une protection contre une exposition directe à la chaleur provenant de la spirale de chauffage (8).

18. Four de durcissement selon les revendications 8 et 17, caractérisé en ce qu'on prévoit, dans la boîte, en plus du capteur de température (67c), au moins deux capteurs (67a, 67b) de la température du gaz, qui sont disposés essentiellement à la même hauteur l'un par rapport à l'autre, et dont un respectivement est attribué au courant de gaz, respectivement des deux gaines à circulation forcée (15, 16) ou des deux gaines de guidage (43, 44) pour capter leur température.

19. Four de durcissement selon la revendication 1, caractérisé en ce que les ventilateurs (9) sont réalisés respectivement sous forme de ventilateur fileté dont l'arbre (10) et le rejet du gaz sont orientés essentiellement parallèlement à la direction longitudinale du magasin (7), ces arbres (10) étant reliés via un couplage magnétique (13) à une commande disposée à l'extérieur de la boîte (R).

20. Four de durcissement selon la revendication 1, caractérisé en ce qu'un arbre (10a, 10b) du ventilateur respectif (17, 17a, 17b), relié à une commande ou à un moteur disposé à l'extérieur de la boîte, traverse une garniture étanche d'arbre (70) disposée contre le logement (1a), qui présente un passage (72) dont le diamètre (d) est supérieur à celui des arbres (10a, 10b) et dans lequel débouche un conduit radial (73) pour l'alimentation d'un gaz, de préférence, un gaz protecteur tel que l'azote.

21. Four de durcissement selon la revendication 1, caractérisé en ce que la porte (6) est reliée via un guidage par parallélogramme (45) à un logement principal (46) contre lequel s'appuie la boîte (R).

22. Four de durcissement selon la revendication 21, caractérisé en ce que le guidage par parallélogramme (45) est constitué respectivement par deux leviers (47, 48) reliés en articulation aux côtés de la porte (6) et au logement principal (46), qui peuvent être mis en mouvement via une commande.

23. Four de durcissement selon la revendication 22, caractérisé en ce qu'une traverse (56), essentiellement horizontale, est disposée entre les deux leviers (48), dans laquelle vient se loger un manchon (52) muni d'un filet interne qui est traversé par une broche (53) fixée à demeure.

24. Four de durcissement selon la revendication 23, caractérisé en ce que la broche (53) est reliée à un moteur (55) via une courroie de commande (54).

25. Four de durcissement selon la revendication 1, caractérisé en ce que le ventilateur est réalisé sous forme de ventilateur fileté (9) et la direction du courant de gaz peut être modifiée en inversant le sens de rotation du ventilateur.

26. Four de durcissement selon la revendication 9, caractérisé en ce que la distribution du courant de gaz dans la boîte (R₂) peut être modifiée périodiquement en inversant simultanément le sens de rotation des deux ventilateurs (17a, 17b).
